# EUROPÄISCHE PATENTANMELDUNG

(11) **EP 3 402 315 A1**
(43) Veröffentlichungstag der Anmeldung: **14.11.2018**
(21) Anmeldenummer: 17170684.9
(22) Anmeldetag: 11.05.2017
(51) Int. Cl.: H05K 7/12

(54) **VERBINDUNGSANORDNUNG UND STECKSYSTEM**

(71) Anmelder: FESTO AG & Co. KG, 73734 Esslingen (DE)
(72) Erfinder: Hermann, Klinger, 73733 Esslingen (DE)
(74) Vertreter: Patentanwälte Magenbauer & Kollegen Partnerschaft mbB

(57) **Zusammenfassung**

Die Erfindung betrifft eine Verbindungsanordnung zur Verwendung in einem elektromechanischen Stecksystem (1), mit einer Trägerplatte (6), an der zwei beabstandet zueinander angeordnete und elektrisch miteinander verbundene Kontaktanordnungen (19, 20) angebracht sind, wobei jede der Kontaktanordnungen (19, 20) einen Stecker (21) zum Einstecken in eine Buchse (23) einer weiteren Verbindungsanordnung (5) sowie eine Buchse (23) zur Aufnahme eines Steckers (21) einer weiteren Verbindungsanordnung (5) umfasst. Erfindungsgemäß ist vorgesehen, dass die Buchse (21) und der Stecker (23) derart aufeinander abgestimmt sind, dass der Stecker (21) in der Buchse (23) ausschließlich in Steckstellungen (26, 27, 28, 29) aufgenommen werden kann, die in einer Winkelteilung von 90 Grad zueinander ausgerichtet sind.

## Beschreibung

Die Erfindung betrifft eine Verbindungsanordnung zur Verwendung in einem elektromechanischen Stecksystem, mit einer Trägerplatte, an der zwei beabstandet zueinander angeordnete und elektrisch miteinander verbundene Kontaktanordnungen angebracht sind, wobei jede der Kontaktanordnungen einen Stecker zum Einstecken in eine Buchse einer weiteren Verbindungsanordnung sowie eine Buchse zur Aufnahme eines Steckers einer weiteren Verbindungsanordnung umfasst. Ferner betrifft die Erfindung ein Stecksystem.

Gemäß einem druckschriftlich nicht niedergelegten Stand der Technik ist eine Verbindungsanordnung bekannt, die aus dem Bereich der Elektro-Baukästen für Kinder und Jugendliche stammt und die zum Aufbau von elektrischen Schaltungen eingesetzt werden kann. Die bekannte Verbindungsanordnung umfasst ein leistenförmig ausgebildetes Kunststoffteil, das jeweils an einander entgegengesetzten Endbereichen mit einer Kontakteinrichtung versehen ist, die in der Art eines Druckknopfs, wie er aus dem Bekleidungsbereich bekannt ist, ausgebildet ist. Hierdurch können mehrere Verbindungsanordnungen elektromechanisch miteinander gekoppelt werden, um variable elektrische Leitungen für Versuchszwecke auszubilden.

Die Aufgabe der Erfindung besteht darin, eine Verbindungsanordnung sowie ein Stecksystem bereitzustellen, die eine erhöhte Bediensicherheit aufweisen.

Diese Aufgabe wird für eine Verbindungsanordnung der eingangs genannten Art mit den Merkmalen des Anspruchs 1 gelöst. Hierbei ist vorgesehen, dass die Buchse und der Stecker derart aufeinander abgestimmt sind, dass der Stecker in der Buchse ausschließlich in Steckstellungen aufgenommen werden kann, die in einer Winkelteilung von 90 Grad zueinander ausgerichtet sind. Durch diese Maßnahme wird gewährleistet, dass ein Aufbau einer elektrischen Schaltung unter Verwendung derartiger Verbindungsanordnungen mit höherer Wahrscheinlichkeit einer vorgegebenen Vorlage entspricht, als dies bei der Verwendung von Verbindungsanordnungen der Fall ist, die eine freie Winkelausrichtung zwischen benachbarten Verbindungsanordnungen ermöglicht. Dementsprechend wird insbesondere jüngeren Nutzern die Verwendung der Verbindungsanordnungen sowie der Aufbau von elektrischen Schaltungen erleichtert, da von vornherein sichergestellt ist, dass ein elektromechanischer Freiheitsgrad für die Kopplung benachbarter Verbindungsanordnungen wahlweise auf zwei, drei oder vier Steckstellungen begrenzt ist. Vorzugsweise sind der Stecker und die Buchse derart aufeinander abgestimmt, dass eine zweite Verbindungsanordnung zumindest in drei jeweils um 90 Grad zueinander versetzten Steckstellungen an einer ersten Verbindungsanordnung angebracht werden kann. Hierbei ist es nicht zwingend erforderlich, dass die zweite Verbindungsanordnung derart an der ersten Verbindungsanordnung festgelegt werden kann, dass die zweite Verbindungsanordnung die erste Verbindungsanordnung überdeckt. Wahlweise ist vorgesehen, dass eine solche Überdeckung zwischen den Verbindungsanordnungen durch zusätzliche mechanische Komponenten an den Verbindungsanordnungen verhindert wird oder gegebenenfalls auch zulässig ist, um beispielsweise eine Parallelschaltung von Verbindungsanordnungen zu ermöglichen.

Vorteilhafte Weiterbildungen der Erfindung sind Gegenstand der Unteransprüche.

Zweckmäßig ist es, wenn in eine elektrische Verbindungsleitung zwischen den beiden Kontaktanordnungen ein an der Trägerplatte festgelegtes elektrisches Bauelement eingeschleift ist. Hierbei ist die zwischen den Kontaktanordnungen ausgebildete Verbindungsleitung abschnittsweise unterbrochen und die Unterbrechung wird durch das Bauelement elektrisch leitend überbrückt. Mit Hilfe des elektrischen Bauelements wird Einfluss auf Eigenschaften der elektrischen Verbindungsleitung zwischen den beiden Kontaktanordnungen genommen. Durch Anordnung und elektromechanischer Kopplung mehrerer solcher Verbindungsanordnungen kann somit die gewünschte elektrische Schaltung aufgebaut werden. Hierbei ist es vorteilhaft, wenn das elektrische Bauelement aus der Gruppe: Widerstand, Kondensator, Diode, Leuchtmittel, Schalter, Taster, ausgewählt ist. Mit derartigen Bauelementen lassen sich eine Vielzahl von einfachen elektrischen Schaltungen aufbauen, ohne dass Schwierigkeiten bei der manuellen Handhabung der Bauelemente auftreten, wie dies gegebenenfalls der Fall sein kann, wenn die Bauelemente unmittelbar und ohne Verwendung der Trägerplatte und der Kontaktanordnungen eingesetzt werden müssten.

Bevorzugt ist vorgesehen, dass das elektrische Bauelement als bedrahtetes Bauelement oder als oberflächenmontierbares Bauelement ausgebildet ist. Bedrahtete Bauelemente weisen typischerweise zwei Anschlussdrähte auf, die durch Bohrungen in der Trägerplatte gesteckt werden, wobei um jede der Bohrungen eine elektrisch leitende Anschlussfläche ausgebildet ist, die mit einem Abschnitt der Verbindungsleitung verbunden ist und die vorzugsweise für eine Bereitstellung einer, insbesondere durch Löten stoffschlüssig hergestellten, elektrisch leitenden Verbindung zwischen dem Anschlussdraht und dem Abschnitt der Verbindungsleitung ausgebildet ist. Oberflächenmontierbare Bauelemente (die auch als SMD-Bauteil - surface mount device - bezeichnet werden) weisen üblicherweise an einander entgegengesetzten Endbereichen ausgebildete Kontaktbereiche auf, die jeweils zur, insbesondere durch Löten stoffschlüssig hergestellten, elektrisch leitenden Verbindung mit einer elektrisch leitenden Anschlussfläche eines Abschnitts der Verbindungsleitung ausgebildet sind.

Bei einer Weiterbildung der Erfindung ist vorgesehen, dadurch gekennzeichnet, dass die Trägerplatte aus einem elektrisch isolierenden Material hergestellt ist und dass die Verbindungsleitung als Leiterbahn auf der Trägerplatte zwischen den Kontaktanordnungen und dem elektrischen Bauelement ausgebildet ist. Vorteilhaft ist es, wenn die Trägerplatte aus einem Material hergestellt ist, wie es in der Herstellung von elektrischen Leiterplatten verwendet wird, beispielsweise einem glasfaserverstärkten Kunstharzmaterial, wie es insbesondere unter der Bezeichnung FR4 vertrieben wird. Ein derartiges Material ist kostengünstig mit einer Vielzahl von unterschiedlichen Bearbeitungsprozessen an die technischen und geometrischen Anforderungen anzupassen, wie sie an die Trägerplatte gestellt werden. Ferner ist ein derartiges Material mit einem industriellen Standardprozess, vorzugsweise einem Fotoätzprozess, kostengünstig mit einer oder mehreren Leiterbahnen zu versehen, die sich insbesondere von der jeweiligen Kontaktanordnung bis zu einer Anschlussfläche erstrecken und beispielhaft aus Kupfer hergestellt sind.

In weiterer Ausgestaltung der Erfindung ist vorgesehen, dass die Buchse und der Stecker einer Kontaktanordnung einstückig ausgebildet sind. Hierdurch wird insbesondere sichergestellt, dass die Kontaktanordnung zuverlässig von außen bereitgestellte elektrische Energie weiterleiten kann.

Bei einer vorteilhaften Weiterbildung der Erfindung ist vorgesehen, dass die Stecker jeweils quadratisch profiliert ausgebildet sind und dass die Buchsen jeweils eine an die Profilierung der Stecker angepasste, quadratisch profilierte Ausnehmung aufweisen. Vorzugsweise sind die Ausnehmung in der Buchse, die zur Aufnahme des Steckers ausgebildet ist, sowie der Stecker mit einer zumindest nahezu identischen, quadratischen Profilierung längs einer Profilierungsachse ausgebildet. Vorzugsweise ist die Profilierungsachse normal zu einer größten Oberfläche der Trägerplatte ausgerichtet. Ferner ist vorzusehen, dass zumindest der Stecker und/oder die Buchse elastisch ausgebildet sind, um einerseits Fertigungstoleranzen ausgleichen zu können und andererseits eine zuverlässige Steckverbindung zwischen Stecker und Buchse gewährleisten zu können. Beispielhaft ist vorgesehen, dass am Stecker oder der Buchse ein Schlitz oder mehrere Schlitze ausgebildet sind, die die gewünschte Elastizität der jeweiligen Komponente gewährleisten.

Zweckmäßig ist es, wenn die Kontaktanordnung als Umformteil aus einem aus Metall hergestellten Rohrabschnitt ausgebildet ist. Bei dieser Ausgestaltung können Kontaktanordnungen kostengünstig und mit hoher Präzision hergestellt werden. Beispielsweise ist vorgesehen, dass die Kontaktanordnung als Tiefziehteil aus einem dünnwandigen Rohrabschnitt hergestellt wird und gegebenenfalls nach der Durchführung des Umformvorgangs mit einer Schutzschicht, insbesondere in einem galvanischen Auftragsverfahren, versehen wird. Bevorzugt ist vorgesehen, dass die Kontaktanordnung zumindest an einem Endbereich mit einem oder mehreren Schlitzen versehen wird, um eine vorteilhafte Elastizität für den Stecker oder die Buchse zu erzielen. Besonders bevorzugt ist vorgesehen, dass die Kontaktanordnung bei einer Herstellung der Verbindungsanordnung in eine Ausnehmung der Trägerplatte eingesteckt wird und wahlweise ergänzend oder alternativ formschlüssig und/oder stoffschlüssig mit der Trägerplatte verbunden wird. Beispielhaft ist vorgesehen, dass die zur Aufnahme der Kontaktanordnung ausgebildete Ausnehmung in der Trägerplatte von einer elektrisch leitenden Kontaktfläche umgeben ist, die elektrisch mit einer Leiterbahn der Verbindungsleitung verbunden ist und die insbesondere für die Herstellung einer Lötverbindung zwischen der Kontaktanordnung der Verbindungsleitung ausgebildet ist.

Bevorzugt ist vorgesehen, dass die Kontaktanordnung als zumindest bereichsweise metallisiertes Kunststoffspritzgussteil ausgebildet ist. Hierdurch wird eine besonders kostengünstige Herstellung der Kontaktanordnung ermöglicht, wobei insbesondere für die Profilierung des Steckers und der korrespondierenden Ausnehmung in der Buchse eine größere Gestaltungsvielfalt ermöglicht ist, als dies bei der Herstellung der Kontaktanordnung als Umformteil aus einem Metallrohrabschnitt der Fall ist. Die Metallisierung kann insbesondere in einem galvanischen Auftragverfahren auf die Kontaktanordnung aufgebracht werden.

Vorteilhaft ist es, wenn die Kontaktanordnung mit einem zwischen Stecker und Buchse angeordneten Verbindungsabschnitt in einer Ausnehmung der Trägerplatte aufgenommen, insbesondere stoffschlüssig festgelegt, ist. Bevorzugt ist vorgesehen, dass eine Lötverbindung zwischen der Kontaktfläche und dem Verbindungsabschnitt hergestellt wird. Diese kann insbesondere in gleicher Weise wie eine Festlegung eines SMD-Bauteils erfolgen, indem zunächst eine gestaltlose Lötpaste auf die Kontaktfläche aufgebracht wird und anschließend die Kontaktanordnung in die von der Kontaktfläche umgebene Ausnehmung montiert wird. Hierbei sind die Geometrien des Verbindungsabschnitts und der Kontaktfläche sowie die Menge und Platzierung der Lötpaste derart aufeinander abgestimmt, dass bei einer nachfolgenden Erwärmung der Trägerplatte mit der darin aufgenommenen Kontaktanordnung die Verlötung zwischen Kontaktanordnung und Kontaktfläche erfolgt. Ergänzend oder alternativ kann vorgesehen sein, dass die Kontaktanordnung nach Montage in die Ausnehmung der Trägerplatte, insbesondere vor einer eventuellen Verlötung, durch einen geeigneten Deformationsprozess kraftschlüssig und/oder formschlüssig an der Trägerplatte festgelegt wird.

Bei einer Weiterbildung der Erfindung ist vorgesehen, dass die Trägerplatte als Planparallelplatte mit rechteckig ausgebildeten größten Oberflächen ausgebildet ist und dass an der Trägerplatte wenigstens eine, insbesondere randseitige, Ausnehmung für einen Eingriff eines Handhabungswerkzeugs ausgebildet ist. Mit Hilfe des Handhabungswerkzeugs, bei dem es sich insbesondere um eine speziell angepasste Zange oder Klammer handeln kann, wird eine vereinfachte Demontage von zusammengefügten Verbindungsanordnungen ermöglicht. Hierzu weist die Trägerplatte wenigstens eine Ausnehmung auf, die an einen Greifbereich des Handhabungswerkzeugs angepasst ist und ein zuverlässiges Ergreifen der Trägerplatte durch das Handhabungswerkzeug gewährleistet.

Die Aufgabe der Erfindung wird ein Stecksystem zum Aufbau von elektrischen Schaltungen mit einem Steckbrett, das eine Vielzahl von rasterartig angeordneten Steckbuchsen zur Aufnahme von Anschlussdrähten elektrischer Bauelemente oder Steckern von Verbindungsanordnungen aufweist sowie mit einer Verbindungsanordnung nach einem der Ansprüche 1 bis 11 gelöst, wobei ein Abstand zwischen den Kontaktanordnungen der Verbindungsanordnung übereinstimmend mit einer Rasterteilung der Steckbuchsen oder einem ganzzahligen Vielfachen der Rasterteilung der Steckbuchsen ausgebildet ist. Die Zielsetzung für das Stecksystem besteht darin, ein handelsübliches Steckbrett in vorteilhafter Weise mit Verbindungsanordnungen, die zumindest teilweise auch mit Bauelementen versehen sein können, zu bestücken, um hierdurch elektrische Schaltungen aufbauen zu können. Gegebenenfalls werden für den Aufbau der elektrischen Schaltung neben den Verbindungsanordnungen und den daran aufgenommenen elektrischen Bauelementen auch weitere elektrische Bauelemente genutzt, die unmittelbar in das Steckbrett eingesteckt werden. Dies ist insbesondere dann von Interesse, wenn komplexere elektrische Bauelemente wie Transistoren, Operationsverstärker oder integrierte Schaltkreise in der Schaltung eine Verwendung finden sollen. In diesem Fall erleichtern die Verbindungsanordnungen die Beschaltung der komplexen elektrischen Bauelemente, da die elektrische Peripherie für das oder die komplexen elektrischen Bauelemente in vereinfachter Weise durch die vorteilhaft handhabbaren Verbindungsanordnungen geschaffen werden kann.

Bei einer Weiterbildung des Stecksystems ist vorgesehen, dass die rasterartig angeordneten Steckbuchsen in zwei zueinander senkrechten Raumrichtungen jeweils die gleiche Rasterteilung aufweisen und zur Aufnahme von Anschlussdrähten mit kreisförmigem Querschnitt ausgebildet sind.

In weiterer Ausgestaltung des Stecksystems ist vorgesehen, dass zur elektromechanischen Kopplung der Kontaktanordnung mit dem Steckbrett jeweils ein Adapterelement vorgesehen ist, das einen Steckzapfen zur Kopplung mit der Steckbuchse sowie einen Aufnahmeabschnitt zur Aufnahme des Steckers der Kontaktanordnung umfasst.

Eine vorteilhafte Ausführungsform der Erfindung ist in der Zeichnung dargestellt. Hierbei zeigt:
- Figur 1: eine schematische Draufsicht auf ein Stecksystem mit einem Steckbrett und einer daran angebrachten Verbindungsanordnung,
- Figur 2: eine vergrößerte Draufsicht auf die Verbindungsanordnung gemäß der Figur 1,
- Figur 3: eine teilweise geschnittene, vergrößerte Vorderansicht auf die Verbindungsanordnung gemäß den Figuren 1 und 2,
- Figur 4: eine vergrößerte Ansicht von unten auf die Verbindungsanordnung gemäß den Figuren 1, 2 und 3 und
- Figur 5: eine vergrößerte schematische Darstellung eines Adapterelements.

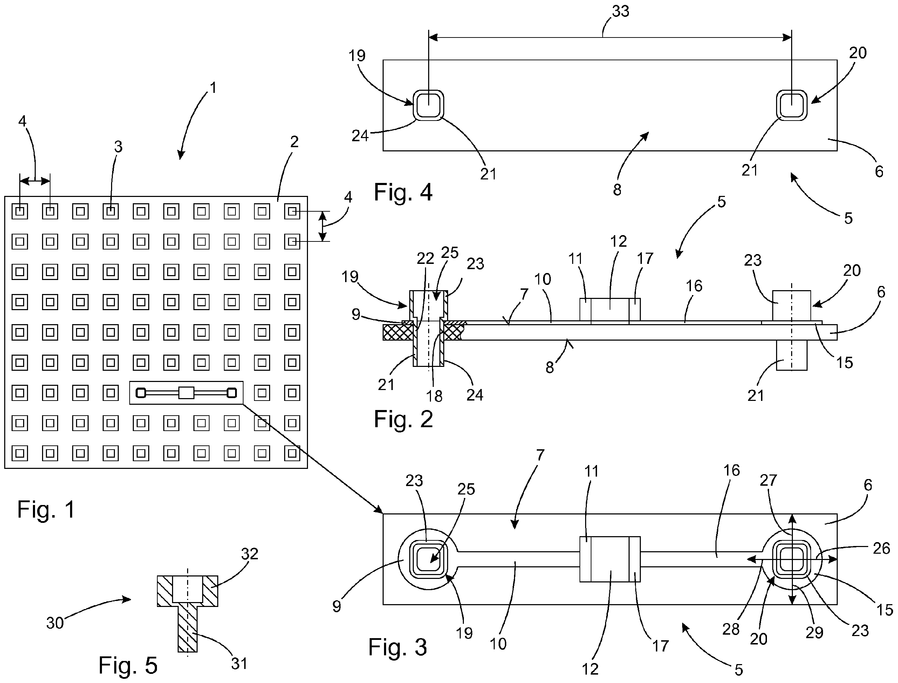

Ein in der Figur 1 dargestelltes Stecksystem 1 umfasst rein exemplarisch ein handelsübliches Steckbrett 2 mit einer Vielzahl von rasterartig angeordneten Steckbuchsen 3. Beispielhaft sind die Steckbuchsen 3 sowohl in einer Längsrichtung des Steckbrett 2 als auch in einer Querrichtung des Steckbretts 2 mit einer identischen Teilung 4 angeordnet. Die Steckbuchsen 3 sind in nicht näher dargestellter Weise zur Aufnahme von ebenfalls nicht dargestellten Anschlussdrähten elektrischer Bauelemente vorgesehen. Beispielsweise können in die Steckbuchsen 3 bedrahtete Widerstände, bedrahtete Dioden, bedrahtete Transistoren oder andere bedrahtete elektrische Bauelemente eingesteckt werden. Innerhalb des Steckbretts 2 verlaufen zwischen den Steckbuchsen 3 nicht dargestellte elektrische Verbindungen, wodurch ein Aufbau von elektrischen Schaltungen auf dem Steckbrett 2 ermöglicht wird.

Um einen Aufbau derartiger elektrischen Schaltungen mit Hilfe des Steckbretts 2 zu erleichtern, können zusätzliche elektrische Bauelemente 12 eingesetzt werden, die auf Verbindungsanordnungen 5 angeordnet sind. In der Figur 1 ist eine Verbindungsanordnung 5 dargestellt, die in nachstehend näher beschriebener Weise mit dem Steckbrett 2 elektromechanisch verbunden ist.

Wie aus den Darstellungen der Figuren 2 bis 4 entnommen werden kann, umfasst die Verbindungsanordnung 5 eine rein exemplarisch als Planparallelplatte ausgebildete Trägerplatte 6, die beispielhaft aus einem glasfaserverstärktem Kunststoff, insbesondere FR4, hergestellt sein kann und die ebenfalls beispielhaft zwei einander entgegengesetzte größte Oberflächen 7, 8 mit jeweils rechteckiger Geometrie aufweist. Wie aus der Darstellung der Figur 3 entnommen werden kann, ist auf der größten Oberfläche 7 ausgehend von einer rein exemplarisch kreisrund und elektrisch leitend ausgebildeten Kontaktfläche 9 eine Leiterbahn 10 bis unter einen Kontaktbereich 11 eines oberflächenmontierbaren elektrischen Bauelements 12 erstreckt. In gleicher Weise erstreckt sich von einer rein exemplarisch kreisrunden und elektrisch leitend ausgebildeten Kontaktfläche 15 eine Leiterbahn 16 bis unter einen Kontaktbereich 17 des Bauelements 12.

Ferner ist exemplarisch vorgesehen, dass die Trägerplatte 6 jeweils mittig im jeweiligen Kontaktbereich 11, 17 mit einer Ausnehmung 18 versehen ist, wie sie in der Darstellung der Figur 2 zu erkennen ist, wobei in die jeweilige Ausnehmung 18 eine Kontaktanordnung 19, 20 montiert ist. Beispielhaft ist vorgesehen, dass ein Abstand 33 der beiden Kontaktanordnungen 19, 20 einem ganzzahligen Vielfachen der Teilung 4 der Steckbuchsen 3 entspricht.

Beispielhaft ist vorgesehen, dass sowohl das elektrische Bauelement 12 als auch die Kontaktanordnungen 19, 20 in nicht näher dargestellter Weise mit den Endbereichen der Leiterbahnen 10, 16 bzw. mit jeweils mit der zugehörigen Kontaktfläche 9, 15 elektrisch leitend und ortsfest verbunden sind, insbesondere durch eine stoffschlüssige Lötverbindung.

Rein exemplarisch sind die Kontaktanordnungen 19, 20 jeweils als, insbesondere einstückige, Umformteile aus metallischen Rohrabschnitten hergestellt. Jede der Kontaktanordnungen 19, 20 umfasst einen rohrförmig ausgebildeten, mit quadratischem Querschnitt hergestellten Stecker 21, einen ebenfalls rohrförmig ausgebildeten, mit quadratischem Querschnitt herstellten Verbindungsabschnitt 22 sowie eine ebenfalls rohrförmig ausgebildete, mit quadratischem Querschnitt hergestellte Buchse 23. Dabei sind eine Außengeometrie 24 des Steckers 21 und eine Geometrie einer Ausnehmung 25 in der Buchse 23 derart aufeinander abgestimmt, dass ein Stecker 21 einer ersten Verbindungsanordnung 5 in nicht näher dargestellter Weise in die Ausnehmung 25 der Buchse 23 einer zweiten Verbindungsanordnung 5 eingesteckt werden kann.

Hierbei wird durch die quadratische Profilierung des Steckers 21 sowie der Ausnehmung 25 gewährleistet, dass der Stecker 21 ausschließlich in vier jeweils rechtwinklig zueinander ausgerichteten Steckstellungen 26, 27, 28 29 in die Ausnehmung 25 der Buchse 23 eingesteckt werden kann. Um einen vorteilhaften elektrischen Kontakt zwischen einem Stecker 21 einer ersten Verbindungsanordnung und einer Buchse 23 einer zweiten Verbindungsanordnung 5 zu gewährleisten, ist es vorteilhaft, wenn der Stecker 21 und/oder die Buchse 23 elastisch ausgebildet sind. Bei der Ausführungsform der Kontaktanordnung 19, 20 gemäß den Figuren 2 bis 4 wird dies durch die dünnwandige Ausgestaltung des Steckers 21 und der Buchse 23 gewährleistet.

Abweichend von dem oberflächenmontierbaren Bauelement 12 können, gegebenenfalls unter geeigneter Abänderung der Trägerplatte 6, auch andere elektrische Bauelemente auf der Trägerplatte 6 angeordnet werden, insbesondere nicht näher dargestellte bedrahtete Bauelemente.

Da handelsübliche Steckbretter 2 üblicherweise für eine Verwendung von bedrahteten Bauelementen ausgelegt sind und dementsprechend die Steckbuchsen 3 zur Aufnahme von Anschlussdrähten mit kreisrundem Querschnitt vorgesehen sind, muss für eine Anbringung von Verbindungsanordnungen 5 am Steckbrett 2 ein Adapterteil 30 zwischen dem Stecker 21 der Verbindungsanordnung 5 und dem Steckbrett 2 vorgesehen werden. Rein exemplarisch ist das Adapterteil 30 rotationssymmetrisch ausgebildet und weist einen kreiszylindrischen Steckzapfen 31 sowie einen hülsenförmig ausgebildeten Aufnahmeabschnitt 32 auf. Dabei ist der Steckzapfen 31 für ein Einstecken in die Steckbuchse 3 vorgesehen, während der Aufnahmeabschnitt 32 zur Aufnahme des Steckers 21 vorgesehen ist.

Bei einer nicht dargestellten, alternativen Ausführungsform der Verbindungsanordnung erstreckt sich zwischen den beiden Kontaktelementen eine durchgehende Leiterbahn als einstückige Verbindungsleitung und die Verbindungsanordnung weist kein elektrisches Bauelement auf.

Bei einer weiteren, ebenfalls nicht dargestellten, alternativen Ausführungsform der Verbindungsanordnung sind mehr als ein elektrisches Bauelement und/oder mehr als zwei Kontaktanordnungen vorgesehen.

Bei einer weiteren, ebenfalls nicht dargestellten, alternativen Ausführungsform des Stecksystems ist das Steckbrett von vornherein auf die Stecker der Verbindungsanordnungen angepasst, so dass keine Adapterteile benötigt werden und ferner bereits durch die Geometrie der Steckbuchsen und die korrespondierende Geometrie der Stecker ein Einstecken der Verbindungsanordnungen ausschließlich in denen jeweils um 90 Grad versetzt zueinander ausgerichteten Steckstellungen ermöglicht ist.

## Patentansprüche

1. Verbindungsanordnung zur Verwendung in einem elektromechanischen Stecksystem (1), mit einer Trägerplatte (6), an der zwei beabstandet zueinander angeordnete und elektrisch miteinander verbundene Kontaktanordnungen (19, 20) angebracht sind, wobei jede der Kontaktanordnungen (19, 20) einen Stecker (21) zum Einstecken in eine Buchse (23) einer weiteren Verbindungsanordnung (5) sowie eine Buchse (23) zur Aufnahme eines Steckers (21) einer weiteren Verbindungsanordnung (5) umfasst, **dadurch gekennzeichnet, dass** die Buchse (21) und der Stecker (23) derart aufeinander abgestimmt sind, dass der Stecker (21) in der Buchse (23) ausschließlich in Steckstellungen (26, 27, 28, 29) aufgenommen werden kann, die in einer Winkelteilung von 90 Grad zueinander ausgerichtet sind.

2. Verbindungsanordnung nach Anspruch 1, **dadurch gekennzeichnet, dass** in eine elektrische Verbindungsleitung (10, 16) zwischen den beiden Kontaktanordnungen ein an der Trägerplatte (6) festgelegtes elektrisches Bauelement (12) eingeschleift ist.

3. Verbindungsanordnung nach Anspruch 2, **dadurch gekennzeichnet, dass** das elektrische Bauelement (12) aus der Gruppe: Widerstand, Kondensator, Diode, Leuchtmittel, Schalter, Taster, ausgewählt ist.

4. Verbindungsanordnung nach Anspruch 2 oder 3, **dadurch gekennzeichnet, dass** das elektrische Bauelement (12) als bedrahtetes Bauelement oder als oberflächenmontierbares Bauelement ausgebildet ist.

5. Verbindungsanordnung nach einem der Ansprüche 1 bis 4, **dadurch gekennzeichnet, dass** die Trägerplatte (6) aus einem elektrisch isolierenden Material hergestellt ist und dass die Verbindungsleitung als Leiterbahn (10, 16) auf der Trägerplatte (6) zwischen den Kontaktanordnungen (19, 20) und dem elektrischen Bauelement (12) ausgebildet ist.

6. Verbindungsanordnung nach einem der vorhergehenden Ansprüche, **dadurch gekennzeichnet, dass** die Buchse (23) und der Stecker (21) einer Kontaktanordnung (19, 20) einstückig ausgebildet sind.

7. Verbindungsanordnung einem der vorhergehenden Ansprüche, **dadurch gekennzeichnet, dass** die Stecker (21) jeweils quadratisch profiliert ausgebildet sind und dass die Buchsen (23) jeweils eine an die Profilierung der Stecker (21) angepasste, quadratisch profilierte Ausnehmung (25) aufweisen.

8. Verbindungsanordnung einem der vorhergehenden Ansprüche, **dadurch gekennzeichnet, dass** die Kontaktanordnung (19, 20) als Umformteil aus einem aus Metall hergestellten Rohrabschnitt ausgebildet ist.

9. Verbindungsanordnung nach einem der Ansprüche 1 bis 7, **dadurch gekennzeichnet, dass** die Kontaktanordnung (19, 20) als zumindest bereichsweise metallisiertes Kunststoffspritzgussteil ausgebildet ist.

10. Verbindungsanordnung einem der vorhergehenden Ansprüche, **dadurch gekennzeichnet, dass** die Kontaktanordnung (19, 20) mit einem zwischen Stecker (21) und Buchse (23) angeordneten Verbindungsabschnitt (22) in einer Ausnehmung (18) der Trägerplatte (6) aufgenommen, insbesondere stoffschlüssig festgelegt, ist.

11. Verbindungsanordnung einem der vorhergehenden Ansprüche, **dadurch gekennzeichnet, dass** die Trägerplatte (6) als Planparallelplatte mit rechteckig ausgebildeten größten Oberflächen (7, 8) ausgebildet ist und dass an der Trägerplatte (6) wenigstens eine, insbesondere randseitige, Ausnehmung für einen Eingriff eines Handhabungswerkzeugs ausgebildet ist.

12. Stecksystem zum Aufbau von elektrischen Schaltungen, mit einem Steckbrett (2), das eine Vielzahl von rasterartig angeordneten Steckbuchsen (3) zur Aufnahme von Anschlussdrähten elektrischer Bauelemente oder Steckern (12) von Verbindungsanordnungen (5) aufweist, mit einer Verbindungsanordnung (5) nach einem der vorhergehenden Ansprüche, wobei ein Abstand zwischen den Kontaktanordnungen (19, 20) der Verbindungsanordnung (5) übereinstimmend mit einer Rasterteilung (4) der Steckbuchsen (3) oder einem ganzzahligen Vielfachen der Rasterteilung (4) der Steckbuchsen (3) ausgebildet ist.

13. Stecksystem nach Anspruch 12, **dadurch gekennzeichnet, dass** die rasterartig angeordneten Steckbuchsen (3) in zwei zueinander senkrechten Raumrichtungen jeweils die gleiche Rasterteilung (4) aufweisen und zur Aufnahme von Anschlussdrähten mit kreisförmigem Querschnitt ausgebildet sind.

14. Stecksystem nach Anspruch 12 oder 13, **dadurch gekennzeichnet, dass** zur elektromechanischen Kopplung der Kontaktanordnung (19, 20) mit dem Steckbrett (2) jeweils ein Adapterelement (31) vorgesehen ist, das einen Steckzapfen (31) zur Kopplung mit der Steckbuchse (3) sowie einen Aufnahmeabschnitt (32) zur Aufnahme des Steckers (21) der Kontaktanordnung (19, 20) umfasst.
